# DEMANDE DE BREVET EUROPEEN

(11) **EP 0 576 344 A1**
(43) Date de publication de la demande: **29.12.1993**
(21) Numéro de dépôt: 93401595.9
(22) Date de dépôt: 22.06.1993
(51) Int. Cl.: H05K 5/00

(54) **Elément d'extension pour boîtier**

(30) Priorité: 24.06.1992 FR 9207756
(71) Demandeur: ALCATEL CIT, F-75008 Paris (FR)
(72) Inventeur: Delpech, Christian, F-91530 Le Val St Germain (FR); Reptin, Francois, F-75014 Paris (FR)
(74) Mandataire: El Manouni, Josiane

(57) **Abrégé**

L'élément d'extension (22) de l'invention est prévu pour un boîtier constitué d'un socle (10) et d'un capot (11).

L'élément d'extension (22) est destiné à être inséré entre le socle (10) et le capot (11) et comporte sur une première de ses parties située du côté du socle (10) un moyen de solidarisation (25) destiné à coopérer avec le moyen de solidarisation (19) du socle (10) et sur la deuxième de ses parties, située du côté du capot (11), un moyen de solidarisation (26) destiné à coopérer avec le moyen de solidarisation (20) du capot. Les première et deuxième partie constituent respectivement un capot et un socle de manière à assurer d'une part un confinement d'un premier produit entre le socle (10) et cette première partie et d'autre part un confinement d'un second produit entre la deuxième partie et le capot (11).

## Description

Le domaine de l'invention est celui des boîtiers destinés à renfermer par exemple des cartes à circuits imprimés sur lesquelles sont montés des composants électroniques. Plus précisément, la présente invention concerne un système modulable comportant un nombre N de boîtiers, chaque boîtier renfermant une carte et les différents boîtiers étant assemblés entre eux de manière aisément séparable.

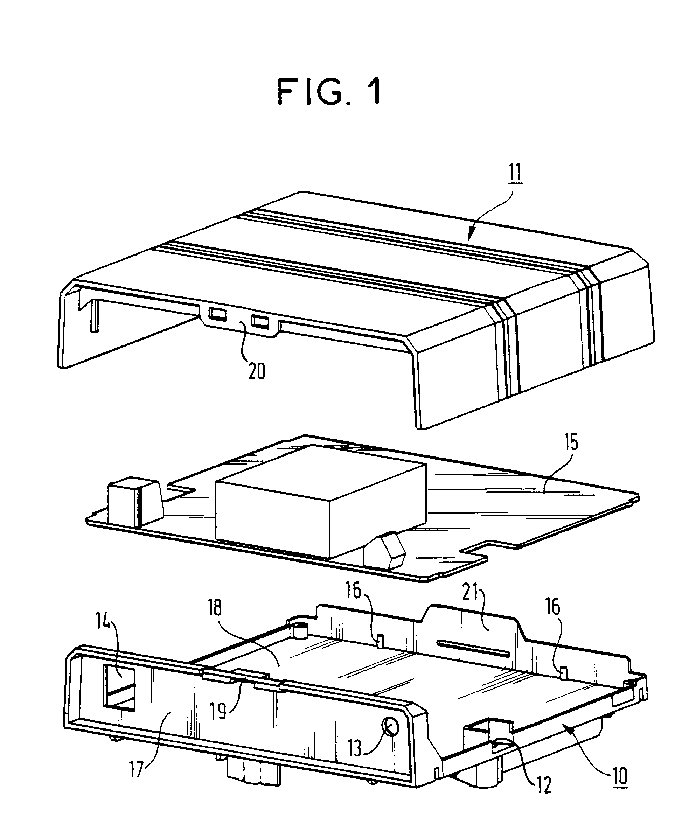

Dans le domaine des télécommunications, et en particulier des liaisons RNIS, il existe chez l'abonné des boîtiers, en général à fixation murale, renfermant des cartes électroniques constituant des terminaisons numériques de réseau. De telles cartes sont raccordées d'une part au réseau de communication (interface U) et d'autre part au bus RNIS (interface S/T). Sur ce bus peuvent être raccordés des terminaux très diversifiés (télécopieur, téléphone, adaptateur, micro-ordinateur,...). Un boîtier destiné à renfermer une telle carte de terminaison numérique de réseau est représenté à la figure 1.

Le boîtier est constitué d'un socle 10 et d'un capot 11, obtenus par exemple par moulage. Le socle 10 comporte deux passages de vis, dont seul un passage 12 est visible, destinés à permettre sa fixation, par exemple contre un mur. Il comporte également des passages de câbles 13 et 14 destinés à être raccordés à une carte 15 de terminaison de réseau, ces passages 13,14 étant situés sous le socle 10 lorsque celui-ci est fixé contre un mur.

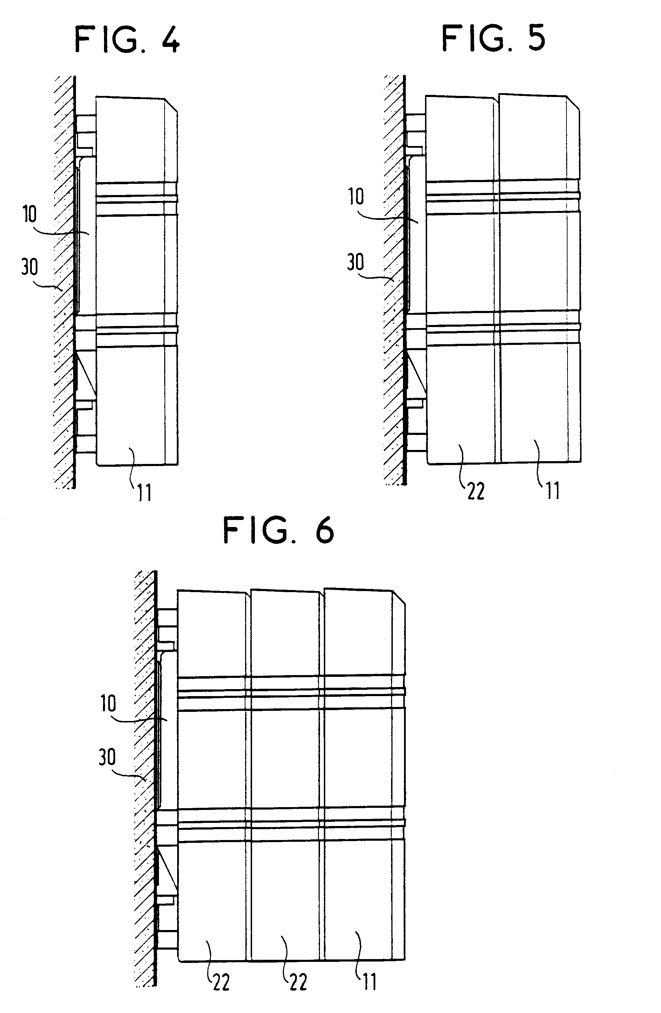

La carte 15 est maintenue dans le socle 10 à l'aide d'ergots 16 coopérant avec des ergots qui leur font face disposés derrière la paroi inférieure 17 du socle 10 et contre la paroi 18 formant la paroi de fond du boîtier. Le capot 11 est solidarisé avec le socle 10 pour assurer une protection de la carte 15 et conférer une certaine étanchéité au boîtier ainsi constitué. Cette solidarisation s'effectue à l'aide d'un mécanisme d'encliquetage 19,20 constitué par des ergots coopérant avec des passages lorsque le capot 11 est appuyé contre le socle 10. Une languette de guidage 21 est prévue pour faciliter un bon positionnement du capot 11 par rapport au socle 10 avant fermeture du boîtier. Le socle 10 et le capot 11 comportent des parois latérales complémentaires de manière à assurer un confinement de la carte 15. Les éléments tels que 19 et 20 formant ledit mécanisme d'encliquetage sont en l'occurrence situés sur de telles parois latérales, l'élément tel que 19 étant en l'occurrence situé sur une paroi latérale, notée 17, du socle 10. L'assemblage obtenu est représenté à la figure 4, cet assemblage étant fixé contre un mur 30.

Dans une application spécifique, huit terminaux peuvent être raccordés au réseau à l'aide d'une telle carte standard. Cependant, lorsque l'utilisateur désire augmenter sa capacité de raccordement, c'est à dire raccorder un nombre de terminaux plus importants, il est nécessaire de fixer un ou plusieurs autres boîtiers à proximité de celui existant, et donc de percer le mur pour permettre le passage des vis de fixation de ces autres boîtiers. Il n'est en effet pas prévu d'incorporer dans le même boîtier plus d'une carte de terminaison de réseau. Ainsi, pour un nombre de boîtiers importants, les opérations d'installation sont fastidieuses et le résultat n'est guère esthétique. Un encombrement important résulte également de la disposition des boîtiers contre le mur.

La présente invention a notamment pour objectif de pallier ces inconvénients.

Plus précisément, un des objectifs de l'invention est de fournir un système de boîtiers permettant d'adapter aisément le nombre de boîtiers en fonction des besoins de l'utilisateur, sans nécessiter de fixation supplémentaire contre un mur et qui limite donc au maximum l'encombrement des boîtiers sur ce mur.

Cet objectif, ainsi que d'autres qui apparaitront par la suite, est atteint grâce à un élément d'extension pour boîtier, le boîtier étant constitué d'un socle destiné à être fixé contre un support et d'un capot, le socle comprenant un premier moyen de solidarisation destiné à coopérer avec un deuxième moyen de solidarisation du capot pour assurer la fermeture du boîtier et le confinement d'un premier produit à l'intérieur du boîtier, l'élément d'extension étant destiné à être inséré entre le socle et le capot et comportant sur une première de ses parties située du côté du socle un troisième moyen de solidarisation destiné à coopérer avec le premier moyen de solidarisation et sur la deuxième de ses parties, située du côté du capot, un quatrième moyen de solidarisation destiné à coopérer avec le deuxième moyen de solidarisation, la partie de l'élément d'extension tournée du côté du socle constituant un capot coopérant avec le socle pour le confinement du premier produit, la partie de l'élément d'extension tournée du côté du capot constituant un socle coopérant avec le capot pour le confinement d'un second produit lorsque les premier et troisième moyens de solidarisation et les deuxième et quatrième moyens de solidarisation respectivement coopèrent entre eux, lesdits moyens de solidarisation étant accessibles de l'extérieur du boîtier, le troisième moyen de solidarisation étant identique au deuxième moyen de solidarisation et le quatrième moyen de solidarisation étant identique au premier moyen de solidarisation.

On dispose ainsi d'un élément d'extension permettant d'obtenir un système de boîtiers modulaire.

Avantageusement, les premier et deuxième moyens de solidarisation constituent un assemblage par coopération de forme manuellement séparable. Il est de cette manière possible d'accéder très facilement à un produit donné.

Préférentiellement, le produit est constitué par une carte à circuit imprimé comportant des composants électroniques.

D'autres caractéristiques et avantages de l'invention apparaîtront à la lecture de la description suivante d'un mode de réalisation préférentiel, donné à titre illustratif et non limitatif, et des dessins annexés dans lesquels:
- la figure 1 est une vue éclatée d'un boîtier à fixation murale de type connu;
- la figure 2 est une vue éclatée d'un assemblage de boîtiers constitué par le boîtier de la figure 1 coopérant avec l'élément d'extension de la présente invention;
- la figure 3 est une vue en coupe de l'assemblage de la figure 2 fixé contre un mur;
- les figures 4,5 et 6 représentent respectivement un boîtier connu fixé contre un mur, le même boîtier muni d'un élément d'extension et enfin ce boîtier muni de deux éléments d'extension.

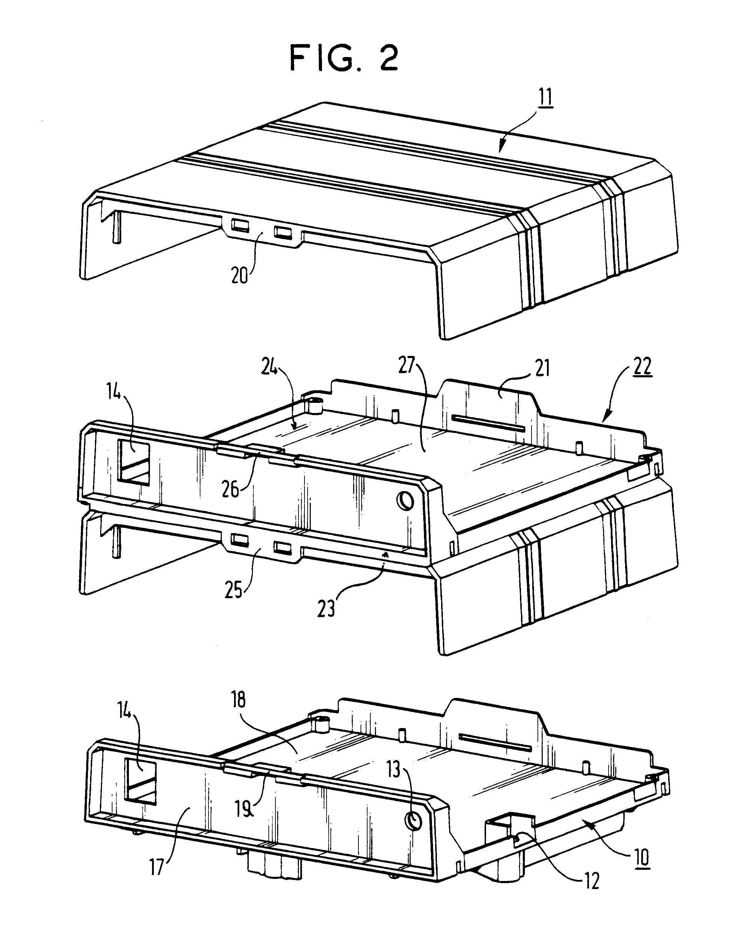

Sur la figure 2 sont représentés le socle 10 et le capot 11 de la figure 1. Entre le socle 10 et le capot 11 est introduit un élément d'extension 22 destiné à renfermer une carte à circuit imprimé telle que 15. L'élément d'extension 22, obtenu par moulage d'un matériau identique à celui du socle 10 et du capot 11, comporte une paroi 27 dont une première face 23 est tournée du côté du socle 10. L'élément d'extension 22 comporte un moyen de solidarisation 25 identique au moyen de solidarisation 20 du capot 11, destiné à coopérer avec le moyen de solidarisation 19 du socle 10. Cette première face 23 comporte des parois latérales identiques à celles du capot 11 et la partie inférieure de l'élément 22 constitue ainsi un capot pour le socle 10. L'élément d'extension 22 comporte également un moyen de solidarisation 26, identique au moyen de solidarisation 19 du socle 10, destiné à coopérer avec le moyen de solidarisation 20 du capot 11, pour le confinement d'une carte à circuit imprimé supplémentaire, pouvant être identique à 15. La seconde face 24 comporte des parois latérales identiques à celles du socle 10, de manière à constituer un socle pour le capot 11. Les moyens de solidarisation 25 et 26 sont localisés de façon à être accessibles de l'extérieur du boîtier, le moyen de solidarisation 26 étant en l'occurrence situé sur l'une des parois latérales de la seconde face 24, identique à celle, notée 17, du socle 10, et notée de la même façon. Les cartes 15 ne sont pas représentées.

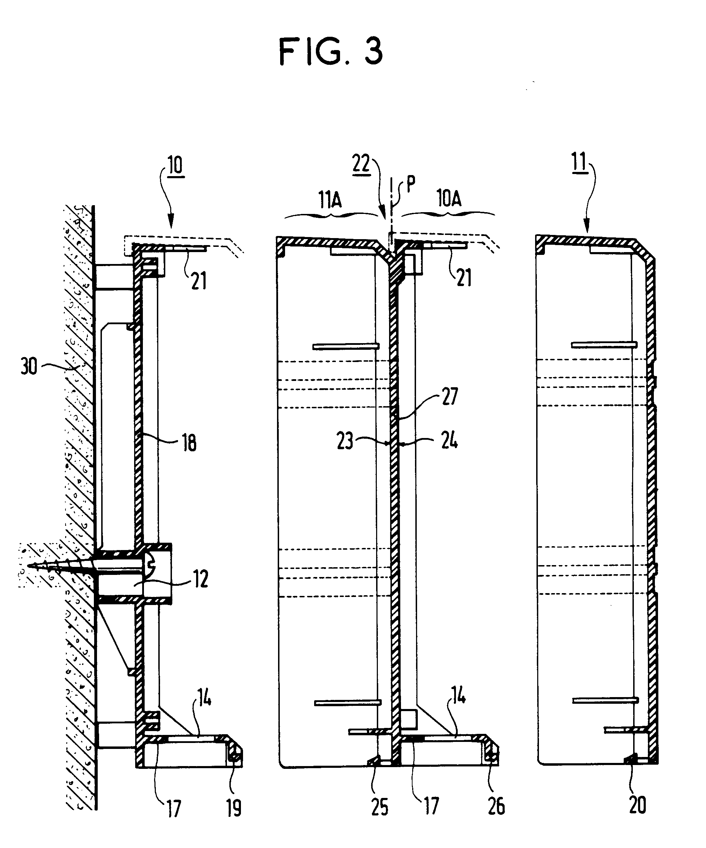

De manière simplifiée, on peut considérer qu'en divisant l'élément d'extension 22 en deux parties selon un plan P (figure 3) passant au milieu de la paroi 27 délimitant les faces 23 et 24, la partie 11A de l'élément d'extension 22 située du côté du socle 10 est sensiblement identique au capot 11 et la partie 10A de l'élément 22 située du côté du capot 11 est sensiblement identique au socle 10. Les différences se situent essentiellement au niveau des passages de vis 12 qui sont inutiles, puisque la fixation de l'élément 22 sur le socle 10 est assurée par l'emboîtement de la partie capot de l'élément d'extension 22 sur le socle 10, dont les formes respectives sont prévues pour coopérer. La fixation est complétée à l'aide des moyens de solidarisation 19,25.

Dans un mode de réalisation préférentiel, ces moyens de solidarisation 19,25 et 20,26 constituent un assemblage par coopération de forme manuellement séparable, tel que prévu dans l'état de la technique pour les moyens de solidarisation 19,20. L'élément 22 est donc adapté aux boîtiers existants et il est aisé de munir de tels boîtiers d'un élément selon l'invention. Pour cela, il suffit d'enlever le capot 11 du boîtier, de monter l'élément 22 sur le socle 10, fixé par exemple au mur 30 comme représenté sur la figure 3, et de monter le capot 11 sur cet élément 22. On dispose ainsi d'un système de boîtiers modulaire, d'autres éléments d'extension 22 pouvant être montés eux-mêmes sur des éléments d'extension qui leur sont identiques.

Sur la figure 3, qui est une vue en coupe de l'assemblage de la figure 2 fixé contre un mur 30, la coopération des différents éléments est représentée en traits pointillés. Dans l'exemple représenté, une fois l'assemblage réalisé, les orifices de passage des câbles sont présents sous cet assemblage. L'assemblage obtenu est représenté à la figure 5. L'accès à n'importe quelle carte à circuit imprimé est immédiat avec un minimum de manipulations.

Le principal avantage de l'invention est qu'elle permet, sans intervention sur les installations préexistantes, l'extension des installations de raccordement au réseau de télécommunications par le raccordement de plusieurs cartes électroniques, chacune étant comprise dans un boîtier dédié, simplement par emboîtage sur un socle de base existant, après retrait de son capot, d'un élément d'extension selon l'invention.

Il est en outre possible, avec l'invention, d'accéder auxdits moyens de solidarisation de l'extérieur du boîtier, et donc d'accéder à l'une quelconque des cartes à circuit imprimé contenues dans ce boîtier, par séparation manuelle des moyens de solidarisation coopérant entre eux pour le confinement de cette carte à circuit imprimé, sans qu'il soit nécessaire de séparer les moyens de solidarisation coopérant entre eux pour le confinement d'autres cartes à circuit imprimé contenues dans ce boîtier, ce qui simplifie et facilite l'accès à une carte donnée contenue dans ce boîtier.

La figure 6 représente un assemblage de deux éléments d'extension préalablement emboîtés l'un sur l'autre, le capot 11 ayant été remis en place sur la partie socle du dernier élément d'extension de l'empilage réalisé.

Le socle 10 n'est bien entendu pas forcément fixé contre un mur mais peut l'être sur tout autre support, vertical ou horizontal.

## Revendications

1. Elément d'extension pour boîtier, ledit boîtier étant constitué d'un socle (10) destiné à être fixé contre un support (30) et d'un capot (11), ledit socle (10) comprenant un premier moyen de solidarisation (19) destiné à coopérer avec un deuxième moyen de solidarisation (20) dudit capot (11) pour assurer la fermeture dudit boîtier et le confinement d'un premier produit à l'intérieur dudit boîtier, ledit élément d'extension (22) étant destiné à être inséré entre ledit socle (10) et ledit capot (11) et comportant sur une première de ses parties (11A) située du côté dudit socle (10) un troisième moyen de solidarisation (25) destiné à coopérer avec ledit premier moyen de solidarisation (19) et sur la deuxième de ses parties (10A), située du côté dudit capot (11), un quatrième moyen de solidarisation (26) destiné à coopérer avec ledit deuxième moyen de solidarisation (20), ladite partie (11A) dudit élément d'extension (22) tournée du côté dudit socle (10) constituant un capot coopérant avec ledit socle (10) pour le confinement dudit premier produit (15), ladite partie (10A) dudit élément d'extension (22) tournée du côté dudit capot (11) constituant un socle coopérant avec ledit capot (11) pour le confinement d'un second produit (15) lorsque lesdits premier (19) et troisième (25) moyens de solidarisation et lesdits deuxième (20) et quatrième (26) moyens de solidarisation respectivement coopèrent entre eux, lesdits moyens de solidarisation étant accessibles de l'extérieur du boîtier, ledit troisième moyen de solidarisation (25) étant identique audit deuxième moyen de solidarisation (20) et ledit quatrième moyen de solidarisation (26) étant identique audit premier moyen de solidarisation (19).

2. Elément selon la revendication 1, caractérisé en ce que lesdits premier et deuxième moyens de solidarisation (19,20) constituent un assemblage par coopération de forme manuellement séparable.

3. Elément selon l'une des revendications 1 et 2, caractérisé en ce que ledit produit est constitué par une carte à circuit imprimé (15) comportant des composants électroniques.
